Europäisches Patentamt

European Patent Office

Office européen des brevets

(11) Veröffentlichungsnummer: **0 000 570**
**B1**

(12) **EUROPÄISCHE PATENTSCHRIFT**

(21) Anmeldenummer: 78100480.9

(22) Anmeldetag: 24.07.78

(51) Int. Cl.³: **G 03 C 7/00, G 03 B 33/00, G 02 B 27/44, G 03 F 1/02**

(54) Original eines optischen Informationsträgers und Verfahren zum Herstellen des Originals

(30) Priorität: 01.08.77 DE 2734581

(43) Veröffentlichungstag der Anmeldung:
07.02.79 Patentblatt 79/03

(45) Bekanntmachung des Hinweises auf die Patenterteilung:
14.01.81 Patentblatt 81/02

(84) Benannte Vertragsstaaten:
BE CH DE FR GB NL

(56) Entgegenhaltungen:
DE - A - 2 703 160
DE - B - 2 657 246
DE - C - 140 907
FR - A - 2 299 661
GB - A - 6 825 AD 1906
GB - A - 11 466 AD 1899
NL - A - 77 00486

J. S. FRIEDMAN: "History of color photography",
second edition, 1968
Teh Focal Press London
Seiten 23—33.

NATURWISSENSCHAFTEN, Vol 63. No. 4, April
1976
M. T. GALE et al.: "Farbenphotographie ohne
Farbstoffe und Silber"
Seiten 180—184.

OPTICS COMMUNICATIONS, vol. 18, No. 3,
August 1976
K. KNOP: "Color pictures using zero diffraction
order of phase grating structures"
Seiten 298—303.

SMPTE JOURNAL, vol. 87, No. 1, Januar 1978
M. T. GALE et al: "Embossed relief images and
their application for color motion pictures"
Seiten 6—8.

E. J. WALL: "The History of Three-Colour
Photography", 1925, American Photographic
Publishing Co. Boston
Seiten 670—681.

(73) Patentinhaber: HOECHST AKTIENGESELLSCHAFT
Postfach 80 03 20
D - 6230 Frankfurt/Main 80 (DE)

(72) Erfinder: Moraw, Roland, Dr.
Buchenweg 4
D - 6201 Naurod (DE)

### Original eines optischen Informationsträgers und Verfahren zum Herstellen des Originals

Die Erfindung betrifft ein Original eines optischen Informationsträgers, bestehend aus einer auf einem Trägermaterial aufgebrachten Aufzeichnungsschicht, die ein eine nach dem Verfahren zur Reliefgitterbildwiedergabe in nullter Beugungsordnung wiedergebbare Information enthaltendes Reliefbild aufweist, das sich aus mehreren in der freien Oberfläche der Aufzeichnungsschicht angeordneten Relief-Teilbildern zusammensetzt, die aus Reliefgittern mit voneinander verschiedenen Gittertiefen bestehen, sowie ein Verfahren zum Herstellen eines Originals.

Mit der aus der Zeitschrift Laser u. Opto-Elektronik Nr. 3/1976, Seiten 16/17 bekannten Technik zur Reliefgitterbildwiedergabe in nullter Beugungsordnung werden gittermäßig gerasterte Bilder erzeugt. Von den Reliefbildern, die beispielsweise drei Grundfarbengittermustern in gelb, magenta und cyan in drei Fotolackschichten entsprechen, werden drei Nickelmatrizen hergestellt, mit denen farblose thermoplastische Folien aus beispielsweise Polyvinylchlorid geprägt werden. Diese Folien werden mechanisch überlagert und bei der Projektion mit konventionellen Projektoren werden von den farblosen Reliefbildern farbige Projektionsbilder erhalten. Die gitterförmige Rasterung erfolgt mit Reliefgittern von rechteckförmigem Querschnitt, wobei die Gitterperiode etwa 1,5 $\mu$m beträgt. Für jeden Farbauszug in magenta, gelb und cyan werden getrennt je eine Nickelmatrize mit unterschiedlicher Relieftiefe erstellt, mit der die getrennten Prägebilder erzeugt werden. Die Relieftiefen sind unterschiedlich, wobei die Relieftiefe beim Cyanauszug am größten und beim Gelbauszug am kleinsten ist. Diese Farbauszugsbilder sind gerastert. Die Prägebilder werden zu einem dreischichtigen Reliefbild überlagert, von dem farbige Bilder projiziert werden können. Die beschriebene Technik ergibt sehr helle Farbbilder großer Auflösung. Die Reliefbilder können durch Prägen relativ billig und schnell vervielfältigt werden.

Ein Nachteil, der die Einführung dieser Technik erschwert, ist der aufwendige Herstellungsprozeß mit drei vollständig getrennten Arbeitsgängen zur Herstellung der einzelnen, den Farbauszügen entsprechenden geprägten Reliefbilder. Ein weiterer Nachteil ist das paßgerechte Zusammensetzen der drei getrennten Prägekopien, von denen jede ein Relief-Teilbild enthält, zu dem für die farbige Projektion erforderlichen Duplikatbild.

Das eingangs beschriebene Original eines Informationsträgers ist aus der Druckschrift DE—A—27 03 160 bekannt, wobei dieses Original aus einem Trägermaterial besteht, auf dem eine Aufzeichnungsschicht aufgebracht ist. Letztere enthält ein die Information wiedergebendes Reliefbild. Das Reliefbild setzt sich aus zwei Relief-Teilbildern in der freien Oberfläche der Schicht zusammen, die aus zwei einander überlagerten Beugungsgittern mit je einer anderen Tiefe bestehen. Diese Beugungsgitter besitzen zueinander eine gegenseitige Winkelversetzung von 60° oder 90° oder einem sonstigen beliebigen anderen Wert. Es ist möglich, beliebige zwei der drei Primärfarben in einem subtraktiven Beugungsfilter mit nur einer Filterfläche genau zu mischen, da die Anzahl der einstellbaren Parameter bei der Anfertigung der Musteraufzeichnung in der Fotolackschicht genau drei beträgt, nämlich die Summe der Dicken der Tiefen der beiden Beugungsgitter, die Erstbelichtungszeit und die Zweitbelichtungszeit. In dieser Druckschrift ist ausdrücklich erwähnt, daß das Verfahren zum Herstellen einer Musteraufnahme sich nicht auf drei überlagerte Gitterstrukturen, wie sie zum Mischen aller drei Primärfarben auf einer einzigen Oberfläche eines subtraktiven Beugungsfilters erforderlich sind, ausweiten läßt, da in diesem Fall acht verschiedene Parameter gebraucht werden, aber nur vier Parameter frei zur Verfügung stehen. Es ist nur möglich, eine der beiden Seiten eines subtraktiven Beugungsfilters mit zwei Gittern für zwei der drei Primärfarben und die andere Seite des Filters mit einem einzigen Gitter für die restliche der drei Primärfarben zu beprägen.

Die Druckschrift GB—A 6 825 beschreibt ein Verfahren, bei dem das farbige Projektionsbild durch Abbildung des gebeugten Lichtes erzeugt wird, wozu entsprechend den Farbauszügen die Farbauszugsbilder mit Gittern unterschiedlicher Gitterkonstanten moduliert werden. Dabei wird versucht, die verschiedenen Gitterbilder in einer Schicht durch Überlagerung von zwei Gittern sehr unterschiedlicher Gitterkonstanten zu speichern. Hierzu wird bei der Farbauszugsbelichtung den eigentlichen farbbestimmenden Gittern mit unterschiedlichen Gitterkonstanten ein relativ grobes Gitter überlagert, das überdies bei jeder Aufnahme in neue Positionen verschoben wird, wobei der Abstand zwischen den einzelnen Positionen kleiner als die Gitterkonstante des groben Gitters ist. Eine derartige Doppel-gitter-Technik mit partieller Verschiebung eines Gitters ist sehr schwierig zu handhaben. Es wird weder mit Relief-gittern einheitlicher Gitterkonstanten und mit rechtecksförmigem Gitterprofil gearbeitet, noch wird das ungebeugte Licht für die Projektion verwendet. Eine derartige Abbildungstechnik führt zu keiner exakten farbgetreuen Projektion der Reliefgitterbilder.

Bei dem in der Druckschrift GB—A 11 466 beschriebenen Verfahren werden zwei oder mehrere Filme mit Farbauszugsgitterbildern übereinandergelegt, wobei die Gitterlinien unterschiedliche Azimut-Winkel besitzen, d.h. die Gitter-Teilbilder zueinandergedreht sind. Es wird dann das jeweils in der ersten Ordnung gebeugte Licht so unter ver schiedenen Winkeln
projiziert, daß sich die Teilbilder überlagern.

In der nicht zum Stand der Technik
gehörenden deutschen Patentschrift 2 657 246
ist eine Lösung angegeben, die die Nachteile bei
der aufwendigen Herstellung der einzelnen, den
Farbauszügen entsprechenden geprägten
Relief-Teilbilder vermeidet.

Danach setzt sich das Reliefbild aus den den
einzelnen Farbauszügen entsprechenden Relief-
Teilbildern in der Weise zusammen, daß
verschiedenfarbige Bereiche, das können bei
gerasterten Bildern auch Rasterpunkte sein, in
einer Ebene angeordnet sind, wobei sich die
verschiedenfarbigen Bereiche nicht überschneiden, sondern höchstens berühren.

Derartige Reliefbilder eignen sich sehr gut zur
Darstellung von flächenhaften mehrfarbigen
Vorlagen, wie graphische Darstellungen, in
Form von Reliefgitterstrukturen in einer Ebene.

Die in dem deutschen Patent 26 57 246
offenbarte Erfindung arbeitet mit drei Grundfarben, die im allgemeinen nicht zur
vorlagenähnlichen Darstellung von bunten Vorlagen mit Mischfarben, beispielsweise von
bunten Landschaftsbildern, ausreichen.

Aufgabe der Erfindung ist es, eine Original
eines Informationsträgers zu schaffen, der für
die Wiedergabe von beliebigen, kompletten
Farbbildern, unter Einschluß von Mischfarben,
geeignet ist.

Diese Aufgabe wird erfindungsgemäß dadurch gelöst, daß mindestens vier Relief-
Teilbilder vorhanden sind, die Relief-Teilbilder
überlappungsfrei aneinander grenzen, und die
Gittertiefen der Relief-Teilbilder so gewählt sind,
daß bei der Projektion mit weißem Licht die
nullte Beugungsordnung die Farben gelb, rot,
blau-violett und grün aufweist.

Die weitere Ausgestaltung des Originals
sowie das Verfahren zum Herstellen eines Originals sind aus den kennzeichnenden Merkmalen der Patentansprüche 2—10 ersichtlich.

Mit der Erfindung wird der Vorteil erzielt, daß
durch die Belichtung der Aufzeichnungsschicht
mit den Farbauszugsvorlagen eines Farbsystems aus beispielsweise vier Grundfarben,
nämlich blau-violett, grün, gelb und rot, das Belichten durch ein Gitter und das Entwickeln der
Aufzeichnungsschicht ein aus einem Reliefbild
bestehendes Original erhalten wird, von dem
infolge der in einer einzigen Ebene befindlichen
Gitterstrukturen mit einer einzigen Prägung eine
Kopie hergestellt werden kann, die beim Projizieren diese vier Grundfarben und sämtliche
daraus durch Verschachtelung erzielbaren
Mischfarben für eine komplettes Farbbild ergibt.

Die Erfindung wird im folgenden anhand der
Zeichnungen näher beschrieben.

Es zeigen:
Fig. 1 in schematischer, perspektivischer Ansicht die Bildung von Mischfarben durch
subtraktive Überlagerung, wie im Stand
der Technik bekannt,
Fig. 2 schematisch in perspektivischer Darstellung die Bildung von Mischfarben
druch additive Zusammensetzung, wie
im Stand der Technik bekannt,
Fig. 3 schematisch die Verschachtelung der
Grundfarben bei der Herstellung eines
Originals,
Fig. 4 eine Anzahl von Rasterelementen mit
schematisch dargestellter abgestufter
Farbintensität nach Fig. 3, und
Fig. 5 eine Vorrichtung zur Rasterung der
Aufzeichnungsschicht.

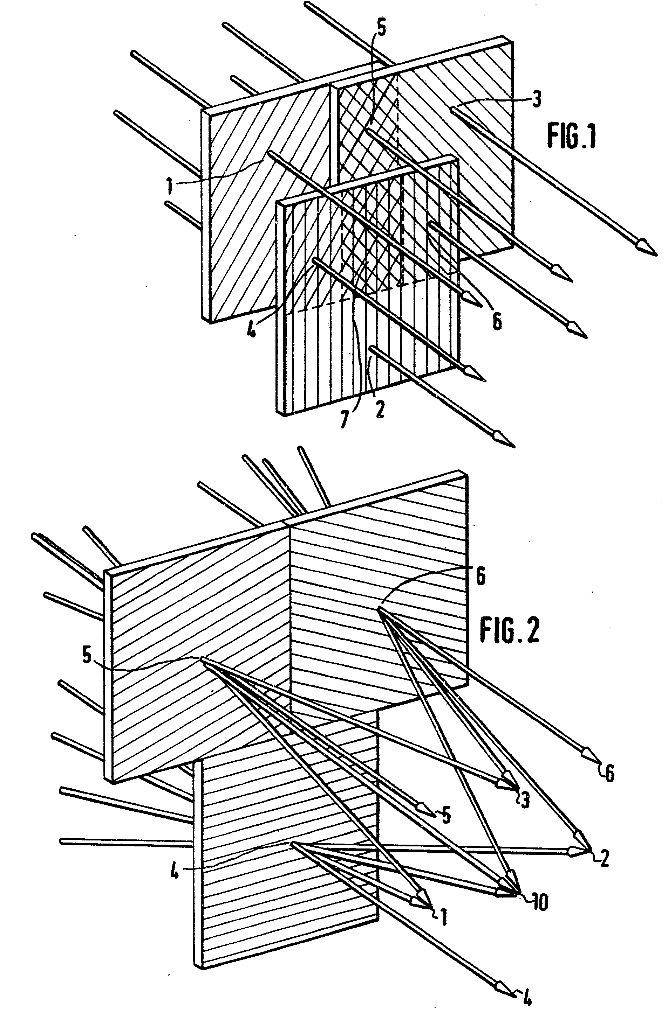

Im Stand der Technik nach dem Verfahren
zur Reliefgitterbildwiedergabe in nullter
Beugungsordnung erfolgt die Bildung einzelner
Farben nach einem subtraktiven Verfahren, das
anhand von Figur 1 erläutert wird. Von den
Grundfarben gelb (1), cyan (2) und magenta (3)
ausgehend werden Mischfarben wie grün (4)
durch Überlagerung von gelben und cyanfarbigen Bereichen gebildet, die als entsprechende Gitterstrukturen auf verschiedene
Folien geprägt werden. Entsprechend werden
rot (5) durch Überlagerung von gelb (1) und
magenta (3) und blau-violett (6) durch
Überlagerung von magenta (3) und cyan (2) gebildet. Die Überlagerung aller Grundfarben ergibt
schwarz (7). Die Überlagerung verschiedenfarbiger
Gitterbereiche für die subtraktive Farbbildung in
einer einzigen Ebene ist naturgemäß nicht möglich, so daß das subtraktive Verfahren nicht anwendbar ist, wenn die Erzeugung von Reliefgitterstrukturen für verschiedene Projektionsfarben in einer Ebene erfolgen soll.

Das gleichfalls bekannte additive Verfahren
geht von den Grundfarben blau-violett (6), grün
(4) und rot (5) aus. Gelb (1) wird beispielsweise
aus grünem (4) und rotem (5) Licht gebildet.
Entsprechend werden cyan (2) und magenta (3)
gebildet. Bei Kopiermaterialien, die nach dem
additiven Farbsystem konzipiert sind, besteht
ein Bildelement, beispielsweise ein Rasterpunkt,
aus je einem grünen (4), roten (5) und violetten
Farbfilterbereich (6), wie Fig. 2 zeigt. Die Farbfilterbereiche sind ohne Überlappungen nebeneinander in einer Ebene angeordnet. Werden
alle drei Farbfilterbereiche durchstrahlt, so
erscheint der Rasterpunkt weiß, werden nur ein
oder zwei Farbfilterbereiche durchstrahlt, so ist
der projizierte Rasterpunkt farbig entsprechend
dem einen oder den beiden durchstrahlten
Farbfilterbereichen.

Der nicht erwünschte Farbanteil kann durch
Abdecken des betreffenden Farbfilterbereiches,
z.B. durch entwickelte Silberkörner in einer fotografischen Schicht, ausgeschaltet werden. Es ist
offensichtlich, daß die Helligkeit von projizierten
Farbbildern nach der additiven Technik nicht so
groß ist wie die von Farbbildern nach der subtraktiven Technik, da im ersten Fall zur Erzeugung einer Farbe nur ein oder zwei Teilbereiche des Rasterpunktes durchstrahlt werden, während im zweiten Fall alle drei Teilbereiche durchstrahlt werden. Ein weiterer Nachteil der beschriebenen additiven Technik ist die Unterteilung der Bildelemente, in der Regel sind das Rasterpunkte, in kleinere Flächen, weil dadurch die Anforderungen bezüglich der Positioniergenauigkeit für Farbauszugsvorlagen bei Belichtungen der Fotolackschicht durch verschiedene Farbauszugsvorlagen merklich ansteigen.

Das erfindungsgemäße Farbsystem ergibt genauso helle Projektionsbilder wie das subtraktive Farbsystem und vermeidet die Schwierigkeiten in bezug auf die Positioniergenauigkeit der Prägekopien, wie sie beim subtraktiven Verfahren auftreten. Letzteres ist eine Folge der kompletten Bildspeicherung in Form von Reliefgitterstrukturen in der Oberfläche einer einzigen Schicht.

Aus der Beschreibung des additiven und subtraktiven Farbsystems mit je drei Grundfarben ist ersichtlich, daß die Schwierigkeit in der Erzeugung der Mischfarben besteht. Um diese Schwierigkeit zu vermeiden, werden nach der Erfindung neben schwarz und weiß vier Grundfarben verwendet. Die Grundfarben sind blauviolett (430—480 nm), grün (510—540 nm), gelb (570—600 nm) und rot (610—650 nm). Diese vier Grundfarben überdecken den sichtbaren Spektralbereich in einer Weise, bei der die lücken zwischen den einzelnen Grundfarbenbereichen viel geringer sind als bei nur drei Grundfarben.

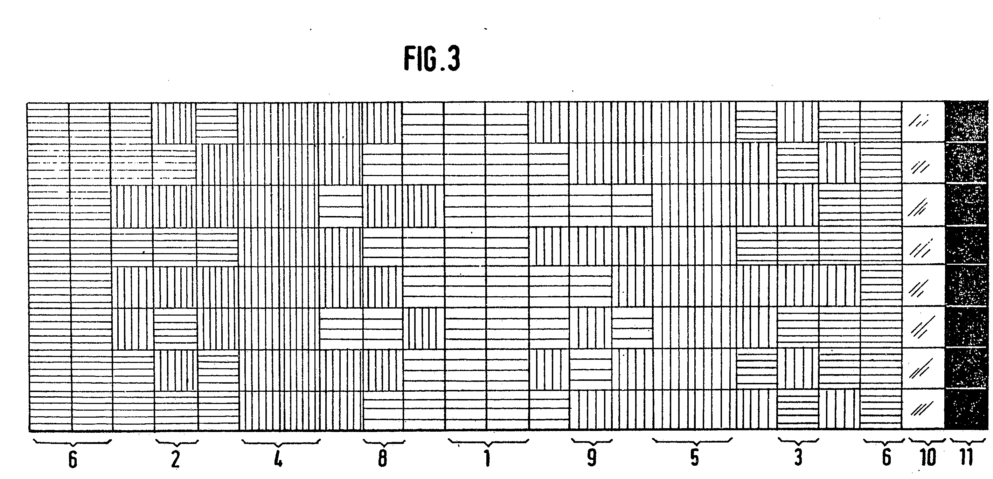

Das wiederzugebende Farbbild kann gerastert, d.h. die Bildfläche in kleine Teilbereiche zerlegt sein. Jeder Rasterpunkt, der nicht schwarz oder weiß ist, enthält nur eine der vier Grundfarben. Mischfarben werden durch Verschachtelung von verschiedenfarbigen Rasterpunkten gebildet, wobei noch die Rasterpunkte einer Farbe unterschiedliche Intensität besitzen können. In Fig. 3 ist dies schematisch dargestellt, in der neben den vier Grundfarben die Mischfarben cyan (2), gelb-grün (8), magenta (3) und orange (9) zu sehen sind. Weiße Rasterpunkte (10) bleiben transparent, schwarze Rasterpunkte (11) sind möglichst wenig lichtdurchlässig.

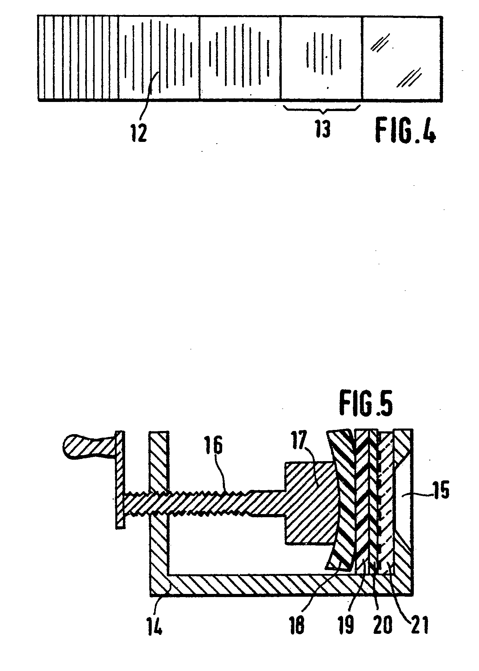

Wie aus Fig. 4 ersichtlich ist, wird die jeweilige Farbintensität durch den Farbe erzeugenden Flächenanteil 12 des jeweiligen Rasterpunktes 13 bestimmt. Der Farbe erzeugende Flächenanteil 12 der Rasterpunkte 13 kann in allen Abstufungen zwischen voller Farbbedeckung mit 100% Belegung an homogener Farbe und fehlender Farbbedeckung gebildet werden.

Die Wiedergabe von bunten Bildern mit Hilfe von vier, die Grundfarben blauviolett/grün/gelb/rot erzeugenden Teilbildern mit entsprechenden Gitterstrukturen in einer Ebene erfolgt durch Projektion über eine Abbildungsoptik. Zur Farbanpassung können die Gitterstrukturen dabei als Rasterpunkte ausgebildet sein. Diese Wiedergabe-Technik ist auch bei Abbildungen durch gerasterte Optiken wie Gitterraster aus Zylinderlinsen oder Kreuzraster aus sphärischen Linsen anwendbar, wofür gleichfalls eine rasterartige Bildzerlegung erforderlich ist. Dabei ist die Gitterkonstante für das Reliefgitter so zu wählen, daß das in der ersten Beugungsordnung abgelenkte Licht auf die Zwischenlinsenbereiche des Linsenrasters fällt.

Für feinere Farbabstufungen kann die Zahl der Grundfarben über vier hinaus erweitert werden. In den meisten Fällen ist die Farbwiedergabe mit vier Grundfarben recht befriedigend. Weiße Bildbereiche werden an gitterfreien Bildstellen gebildet oder an Bildstellen mit Strukturen, die nur einen relativ geringen Beugungseffekt bewirken. Die Farbe schwarz, die in der Praxis oft durch tiefes Dunkelbraun oder tiefes Dunkelviolett angenähert wird, geht von stark strukturierten Bildstellen aus, die keinen ausgeprägten Farbeffekt zeigen. Beispielsweise treten bei Reliefgittern in Fotolacken mit rechteckförmigem Querschnitt bei Gittertiefen zwischen 0,5 $\mu$m und etwa 1 $\mu$m sehr dunkle Brauntöne oder Blautöne auf.

Bei der Herstellung von Kopien des Originals wird von den Reliefstrukturen in der Fotolackschicht des Originals eine Nickelmatrize abgenommen, mit der eine thermoplastische Folie aus beispielsweise Polyvinylchlorid geprägt wird. Wenn der Brechungsindex der Fotolackschicht und der Brechungsindex der thermoplastischen Folie gleich sind, beispielsweise 1,5 betragen, tritt an den Prägebildern keine Farbverzerrung auf. Bei Unterschieden in den Brechungsindizes muß die Relieftiefe in der Fotolackschicht so eingestellt werden, daß das Prägebild die gewünschten Projektionsfarben richtig wiedergibt. Ein Maß für die Tiefenanpassung ist der durch die Gittertiefe vorgegebene optische Weglängenunterschied $d \cdot (n_1 - n_2)$ mit $d$ = Relieftiefe, $n_1$ = Brechungsindex des Gittermaterials und $n_2$ = Brechungsindex des äußeren Mediums, bei Luft ist $n_2 = 1$ in der Praxis. Es werden die vier Grundfarben blau-violett, grün, gelb und rot bei optischen Weglängenunterschieden von etwa 0,3/1,2/0,6/0,8 $\mu$m erhalten, dies entspricht rechnerisch Relieftiefen im Fotolack zwischen etwa 0,6 $\mu$m und 2,4 $\mu$m. In der Praxis wurden für eine optische Weglänge von 1,2 $\mu$m, abweichend vom rechnerischen Wert von 2,4 $\mu$m, ein Wert von 2,1 $\mu$m gemessen.

Geeignete Verfahren zur Reliefbilderzeugung sind in dem deutschen Patent 26 57 246 angegeben. Eine Fotolackschicht auf einem Glas- oder Filmträger wird durch Farbauszugsvorlagen, im Sinne der vorliegenden Erfindung durch je eine für blau-violett, grün, gelb und rot, so belichtet, daß nach der Entwicklung an den betreffenden Bildstellen Reliefstrukturen der gewünschten Gittertiefe entstanden sind. Dabei werden weiße Bildstellen durch Über- oder Unterbelichtung gebildet. Schwarze Bildstellen werden durch Belichtung durch geeignete Vorlagen zur Erzeugung von das Projektionslicht möglichst panchromatisch ablenkenden Strukturen gebildet. Sorgfalt erfordert das jeweilige paßgerechte Auflegen der Farbauszugsvorlagen auf die Fotolackschicht, besonders bei gerasterten Bildern. Je nach angestrebter Bildqualität werden übliche 120er Raster (120 Rasterperioden/cm) oder feinere Raster bis zu Rasterpunkten von 10 $\mu$m Durchmesser verwendet, die Positioniergenauigkeiten zwischen 10 $\mu$m und 1 um erfordern. Die benutzten Farbauszugsvorlagen einschließlich der Schwarzauszugsvorlage sind so beschaffen, daß sie nur an den jeweils zu bebildernden Stellen transparent sind. Für weiße Bildstellen ist die Variante möglich, daß an diesen Stellen mindestens zwei oder mehr Vorlagen transparent sind, da schon durch die Zweifach-Belichtung durch diese Stellen hindurch eine derart intensive Belichtung erfolgt, daß die Fotolackschicht ausbelichtet wird. Große Sorgfalt erfordert die gittermäßige Belichtung, insbesondere der Kontakt von Fotolackschicht und Gittervorlage. Dies gilt vor allem für Gittervorlagen mit großen Liniendichten um 600 Linien/mm, die beispielsweise aus Metallstegen auf Glasplatten bestehen, bei denen der Andruck in üblichen Vakuumkopierrahmen nicht zuverlässig ausreicht. Deshalb erfolgt die Belichtung vorzugsweise in einer in Fig. 5 schematisch dargestellten Spindelpresse aus einem Winkelrahmen 14 mit einer Lichteintrittsöffnung 15 sowie einer Spindel 16. Ein gewölbter Spindelkopf 17 trägt eine elastische Schicht 18, die das Aufzeichnungsmaterial aus einem Träger 19 und einer Fotolackschicht 20 gegen die Gittervorlage 21 anpreßt.

Zur Originalherstellung wird von etwa 2,5 $\mu$m dicken Schichten aus Fotolack ausgegangen, die bildmäßig und gittermäßig belichtet werden. Die bildmäßige Belichtung erfolgt vorzugsweise im Kontakt mit der jeweiligen Farbauszugsvorlage, die gittermäßige Belichtung im Kontakt mit einer Gittervorlage, beispielsweise einer Glasplatte mit lichtdurchlässigen Stellen und mit durch Metallstege lichtundurchlässig abgedeckten Stellen. Bei den bevorzugten positiven Fotolacken mit o-Chinondiaziden, bei denen die belichteten Schichtteile bei der Entwicklung weggelöst werden, wird aktinisches Licht eingestrahlt, beispielsweise paralleles Licht einer 200 Watt-Quecksilberhochdrucklampe durch eine Quarzlinse mit der Brennweite f = 15 cm und durch ein Blauglasfilter mit maximaler Transmission von 75% der Lichtintensität bei 400 nm Wellenlänge. Zur Herstellung einer Metallmatrize zum Prägen des Informationsträgers wird das Original mit einer dünnen elektrisch leitenden Schicht beschichtet, auf der galvanisch ein Metallüberzug abgeschieden wird. Anschließend werden das Original und der Metallüberzug, dessen Kontaktfläche mit dem Original das Negativ-Reliefbild des Originals darstellt, voneinander getrennt. Ein verformbares Material, aus dem der Informationsträger erzeugt wird, beispielsweise Polyvinylchlorid, wird mit der so hergestellten Metallmatrize in an sich bekannter Weise unter Druck und unter meist temperaturbedingter Viskositätserniedrigung geprägt.

## Beispiel

Eine etwa 2.5 $\mu$m dicke Schicht aus positiv arbeitendem Fotolack wird durch Schleudern und Trocknen auf einer blanken transparenten Polyesterfolie aufgebracht. Anschließend wird diese Schicht unter Druck in Kontakt mit einem Gitter von 600 Linien/mm aus Metallstegen auf einer Glasplatte gebracht und mit aktinischem Licht mit einer Energiedichte von 280 mWs/cm² bestrahlt. Diese Energiedichte wird zur gitterförmigen Ausbelichtung der Fotolackschicht bis zum Polyesterträger benötigt.

In Vorversuchen wurde festgestellt, daß bei gleicher Intensität und zunehmenden Belichtungszeiten Projektionsfarben in der Reihenfolge braungelb / magenta / blau-violett / gelb / rot / magenta / cyan / blaugrün / grün / gelbgrün / magenta auftreten, und bei weiter zunehmenden Belichtungszeiten die Projektionsfarben in umgekehrter Reihenfolge erscheinen.

Die erste Reihenfolge der Farben ist auf zunehmende Gittertiefen in der Aufzeichnungsschicht zurückzuführen, während die Umkehr der Farbenreihe die Folge von abnehmenden Gittertiefen durch Überbelichtung der Schicht ist. Dabei wird infolge unvermeidlichen Streulichts die Fotolackschicht auch an den Gitterstegen mehr und mehr entwickelbar.

Nach der Ausbelichtung werden nacheinander die verschiedenen Farbauszugsvorlagen mit einem Rastermuster entsprechend einem 120er Raster in Kontaktanordnung aufgelegt, und es wird je nach angestrebter Projektionsfarbe verschieden lang belichtet. Die Farbauszugsvorlagen sind nur an den Stellen der jeweils gewünschten Projektionsfarben und an den weißen Bildstellen transparent. Die paßgerechte Auflage der Farbauszugsvorlagen auf der Aufzeichnungsschicht erfolgt mit Hilfe von Paßkreuzen bei gelbem Sicherheitslicht unter einem Mikroskop. Es werden für die Projektionsfarben grün / rot / gelb / blau / violett beispielsweise 110/130/150/220 mWs/cm² eingestrahlt. Diese Energiedichten wurden in Vorversuchen ermittelt. Die Schwarzauszugsvorlage enthält in den betreffenden Bildbereichen ein Gittermuster von ca. 300 Linien/mm, das zur bereits aufbelichteten Gitterstruktur senkrecht oder auch geneigt orientiert ist; es werden etwa 150 mWs/cm² eingestrahlt. Die erhaltene Projektionsfarbe ist ein dunkles Graubraun. Entwickelt wird mit wäßrigem alkalischem Entwickler. Bei der Projektion des Reliefbildes mit einer Optik der Lichtstärke 1 : 2,8 wird ein buntes, der Originalvorlage ähnliches Bild mit Mischfarben in entsprechend abgestuften Farbintensitäten erhalten. Weiße Bildstellen werden weiß wiedergegeben, schwarze Bildstellen der Originalvorlage dunkelbraun.

In einem zweiten Versuch wurden die Energiedichten für die Belichtung durch die Farbauszugsvorlagen hindurch auf 105/125/140/205 mWs/cm² festgelegt. Anschließend wurde das entwickelte Reliefbild mit einer dünnen Kupferschicht bedampft, auf der galvanisch Nickel abgeschieden wurde. Mit der hergestellten Nickelmatrize wurde bei ca. 130°C in einer Presse eine Polyvinylchloridfolie geprägt. Das durch eine einzige Prägung entstandene Reliefbild in der Polyvinylchloridfolie ergab bei der Projektion im ungebeugten Strahlengang ein farbiges Bild, das dem Projektionsbild vom Originalreliefbild weitgehend glich.

## Patentansprüche

1. Original eines optischen Informationsträgers, bestehend aus einer auf einem Trägermaterial aufgebrachten Aufzeichnungsschicht, die ein eine nach dem Verfahren zur Reliefgitterbildwiedergabe in nullter Beugungsordnung wiedergebbare Information enthaltendes Reliefbild aufweist, das sich aus mehreren in der freien Oberfläche der Aufzeichnungsschicht angeordneten Relief-Teilbildern zusammensetzt, die aus Reliefgittern mit voneinander verschiedenen Gittertiefen bestehen, dadurch gekennzeichnet, daß
a) mindestens vier Relief-Teilbilder vorhanden sind,
b) die Relief-Teilbilder überlappungsfrei aneinander grenzen und
c) die Gittertiefen der Relief-Teilbilder so gewählt sind, daß bei der Projektion mit weißem Licht die nullte Beugungsordnung die Farben gelb, rot, blau-violett und grün aufweist.

2. Original nach Anspruch 1, dadurch gekennzeichnet, daß wietere Relief-Teilbilder (2, 3, 8, 9) mit die Projektionsfarben blau, magenta, gelb-grün, orange ergebenden Gittertiefen vorgesehen sind.

3. Original nach den Ansprüchen 1 oder 2, dadurch gekennzeichnet, daß es außerdem von den Relief-Teilbildern (1 bis 6, 8, 9) räumlich getrennte transparente Bereiche (10) ohne Gitterstrukturen enthält.

4. Original nach einem der Ansprüche 1 bis 3, dadurch gekennzeichnet, daß es zusätzlich zu den Relief-Teilbildern (1 bis 6, 8, 9) mit Gittertiefen entsprechend den gewünschten Projektionsfarben, Relief-Teilbilder (11) mit rechteckförmigen Gitterstrukturen aufweist, die die Intensität des Projektionslichtes über den gesamten sichtbaren Spektralbereich schwächen.

5. Original nach Anspruch 1, dadurch gekennzeichnet, daß jedes der Relief-Teilbilder (1, 4, 5, 6) aus jeweils einer Grundfarbe zugeordneten Rasterpunkten besteht.

6. Original nach Anspruch 5, dadurch gekennzeichnet, daß die zu den einzelnen Grundfarben gehörigen Rasterpunkte in der Aufzeichnungsschicht (20) überlappungsfrei nebeneinander angeordnet und miteinander verschachtelt sind.

7. Original nach einem der Ansprüche 1 bis 6, dadurch gekennzeichnet, daß die Relief-Teilbilder (1 bis 6, 8, 9) Gittertiefen aufweisen, die Unterschiede in den optischen Weglängen von 0,3 $\mu$m bis 1,3 $\mu$m erzeugen.

8. Verfahren zum Herstellen eines Originals nach Anspruch 1, bei dem die Aufzeichnungsschicht durch getrennte Farbauszugsvorlagen hindurch informationsmäßig belichtet wird, die in den Bereichen der jeweiligen Projektionsfarbe der einzelnen Farbauszugsvorlage transparent sind, dadurch gekennzeichnet, daß
a) zunächst die gesamte Oberfläche der Aufzeichnungsschicht gleichmäßig mit einem Gittermuster belichtet wird,
b) danach durch Farbauszugsvorlagen für Blau-Violett, Grün, Gelb und Rot hindurch informationsmäßig belichtet wird, wobei die Relief-Teilbilder überlappungsfrei aneinandergefügt werden und
c) die Aufzeichnungsschicht entwickelt wird.

9. Verfahren nach Anspruch 8, dadurch gekennzeichnet, daß durch eine Auszugsvorlage für Schwarz hindurch die Aufzeichnungsschicht belichtet wird und daß bei dieser Belichtung gitterförmige Reliefstrukturen erzeugt werden, die das weiße Projektionslicht panchromatisch schwächen.

10. Verfahren nach den Ansprüchen 8 und 9, dadurch gekennzeichnet, daß die gittermäßige Belichtung unter Andruck der Aufzeichnungsschicht an die Gittervorlage erfolgt.

## Revendications

1. Original d'un support d'information optique comprenant une couche d'enregistrement appliquée sur une matière de support, dans laquelle il se trouve une image en relief contenant une information pouvant être reproduite selon un procédé pour la reproduction d'images en réseaux en relief dans l'ordre de diffraction zéro, cette image en relief étant composée de plusieurs images partielles en relief, disposées à la surface libre de la couche d'enregistrement, ces images partielles étant composées de grilles en relief, ayant des profondeurs de relief différentes, caractérisé en ce que:
a) il y a au moins quatre images partielles en relief,
b) les images partielles en relief s'avoisinent sans superposition et,
c) les profondeurs de grille des images partielles en relief sont choisies de telle façon qu'à la projection avec de la lumière blanche, l'ordre de diffraction zéro comprend les couleurs jaune, rouge, bleu-violet et vert.

2. Original selon la revendication 1, caractérisé en ce que d'autres images partielles en relief (2, 3, 8, 9) sont prévues dont les profondeurs de grille donnent les couleurs de projection bleu, magenta, jaune-vert et orange.

3. Original selon la revendication 1 ou 2, caractérisé en ce qu'il contient en dehors des images partielles en relief (1 à 6, 8, 9) des zones transparentes (10), séparées dans l'espace sans structures à réseaux.

4. Original selon l'une quelconque des revendications 1 à 3, caractérisé en ce qu'il comprend additionnellement aux images partielles en relief (1 à 6, 8, 9), ayant des profondeurs de grille correspondant aux structures de réseaux souhaitées, des images partielles en relief (11), ayant des structures à réseaux rectangulaires qui affaiblissent l'intensité de la lumière de projection sur toute l'étendue du domaine spectral visible.

5. Original selon la revendication 1, caractérisé en ce que chacune des images partielles en relief (1, 4, 5, 6) est composée des points de trame appartenant à une couleur fondamentale.

6. Original selon la revendication 5, caractérisé en ce que les points de trame appartenant à chacune des couleurs fondamentales sont disposés côte à côte et sans superposition et sont intercalés.

7. Original selon l'une quelconque des revendications 1 à 6, caractérisé en ce que les images partielles en relief (1 à 6, 8, 9) possèdent des profondeurs de relief qui provoquent des différences entre les parcours optiques comprises entre 0,3 $\mu$m et 1,3 $\mu$m.

8. Procédé pour la fabrication d'un original selon la revendication 1 dans lequel on expose la couche d'enregistrement selon une information, à travers des modèles de sélection colorée, qui sont transparents dans les domaines de la couleur de projection de chaque modèle de sélection colorée, caractérisé en ce que:

a) on expose d'abord toute la surface de la couche d'enregistrement de façon uniforme avec un échantillon de grille,

b) ensuite, on expose selon une information à travers des modèles de sélection colorée pour le bleu-violet, le vert, le jaune et le rouge, en joignant les images partielles en relief sans superposition et,

c) on développe la couche d'enregistrement.

9. Procédé selon la revendication 8, caractérisé en ce que l'exposition à la lumière de la couche d'enregistrement à travers un modèle de sélection pour le noir et en ce qu'il se crée pendant cette exposition des structures en relief en forme de grille, qui affaiblissent la lumière de projection blanche de façon panchromatique.

10. Procédé selon la revendication 8 ou 9, caractérisé en ce que l'exposition sous une grille s'effectue en pressant la couche d'enregistrement contre un modèle à réseaux.

## Claims

1. An original of an optical information carrier, comprising a carrier material and a recording layer which has been applied to said carrier material and contains a relief image for reproducing in zero order diffraction color projection an information stored in said relief image, the relief image being composed of a plurality of relief part-images on the free surface of the recording layer, said relief part-images comprising relief grids having different grid depths in the areas of the individual relief part-images, characterized in that

a) there are at least four relief part-images

b) said relief part-images adjoin one another without overlapping, and

c) the grid depths of said relief part-images are selected in such a way that the zero order diffraction color projection with white light provides the colors yellow, red, blue-violet, and green.

2. An original according to claim 1, characterized in that further relief part-images (2, 3, 8, 9) are provided which have grid depths corresponding to the projection colors blue, magenta, yellow-green, and orange.

3. An original according to claim 1 or 2, characterized in that it additionally comprises transparent areas (10) having no grid structures and being arranged spacially separately from the relief part-images (1 through 6, 8, 9).

4. An original according to any of claims 1 through 3, characterized in that — in addition to the relief part-images (1 through 6, 8, 9) with grid depths corresponding to the desired projection colors — it comprises relief part-images (11) having rectangular grid structures which attenuate the intensity of the projected light over the entire visible range of the spectrum.

5. An original according to claim 1, characterized in that each of the relief part-images (1, 4, 5, 6) represents a screen dot area in one of the base colors.

6. An original according to claim 5, characterized in that the screen dots of the individual base colors are adjacently arranged in the recording layer (20) without overlapping, and in that they are interlaced.

7. An original according to any of claims 1 through 6, characterized in that the grid structures of the relief part-images (1 through 6, 8, 9) have depth differences causing differences in optical path lengths from 0.3 $\mu$m to 1.3 $\mu$m.

8. A process for the preparation of an original as defined in claim 1, wherein the recording layer is exposed information-wise through the individual color separation originals which are transparent in the areas of the appropriate projection color in the particular color separation original, characterized in that

a) first the entire surface of the recording layer is uniformly exposed to a grid pattern.

b) then an information-wise exposure is carried out through color separation originals corresponding to blue-violet, green, yellow and red, whereby the relief part-images adjoin one another without overlapping,

c) the recording layer is developed.

9. A process according to claim 8, characterized in that the recording layer is exposed through a separation original for black, and in that grid-like relief structures are formed during this exposure which attenuate the white projection light panchromatically.

10. A process according to claims 8 and 9, characterized in that the grid-wise exposure is carried out while pressing the recording layer against the grid original.

0 000 570

**FIG.1**

**FIG.2**

FIG.3

0 000 570

FIG.4

FIG.5